# EUROPEAN PATENT SPECIFICATION

(11) **EP 3 151 253 B1**
(45) Date of publication and mention of the grant of the patent: **10.11.2021**
(21) Application number: 15799816.2
(22) Date of filing: 12.05.2015
(51) Int. Cl.: H01F 1/26, H05K 9/00, H01F 1/37

(54) **SOFT MAGNETIC RESIN COMPOSITION AND SOFT MAGNETIC FILM**
WEICHMAGNETISCHE HARZZUSAMMENSETZUNG UND WEICHMAGNETISCHE FOLIE
COMPOSITION DE RÉSINE MAGNÉTIQUE DOUCE ET FILM MAGNÉTIQUE DOUX

(30) Priority: 29.05.2014 JP 2014111612; 23.04.2015 JP 2015088690
(43) Date of publication of application: 05.04.2017
(73) Proprietor: Nitto Denko Corporation, Ibaraki-shi, Osaka 567-8680 (JP)
(72) Inventor: MATSUTOMI, Akihito, Ibaraki-shi Osaka 567-8680 (JP); KAMAKURA, Nao, Ibaraki-shi Osaka 567-8680 (JP); HABU, Takashi, Ibaraki-shi Osaka 567-8680 (JP)
(74) Representative: Hoffmann Eitle
(86) International application number: PCT/JP2015/063643
(87) International publication number: WO 2015/182375

(56) References cited:
- WO-A1-2008/053737
- JP-A- 2009 059 752
- JP-A- 2012 212 790
- JP-A- 2012 212 790
- JP-A- 2014 069 409
- US-A1- 2009 110 587
- US-A1- 2010 001 226

## Description

### TECHNICAL FIELD

The present invention relates to a soft magnetic resin composition and a soft magnetic film. In particular, the present invention relates to a soft magnetic resin composition and a soft magnetic film formed therefrom.

### BACKGROUND ART

Recently, it is known that a soft magnetic film with excellent magnetic permeability is provided in electronic devices for suppressing noises in electronic devices. In production processes of electronic devices, electronic components are disposed on a substrate to which the soft magnetic film is disposed using solder, and thereafter, the solder is heated in a reflow oven (reflow soldering), thereby electrically connecting the substrate with the electronic components.

Patent Document 1 has proposed, as such a soft magnetic film, for example, a composite magnetic substance containing a resin composition containing bisphenol epoxy resin, synthetic rubber, and phenol resin, and soft magnetic metal powder, wherein the soft magnetic metal powder content relative to the composite magnetic substance is 54 vol% (for example, see Patent Document 1 below.). The composite magnetic substance of Patent Document 1 rarely causes deformation deficiencies in reflow soldering, therefore is excellent in reflow resistance. US 2010/001226 A1 discloses a sheet-like soft magnetic material that is formed from a soft magnetic composition which is formed by mixing at least a flat soft magnetic powder, an acrylic rubber, an epoxy resin, a curing agent for the epoxy resin, and a solvent. The flat soft magnetic powder is arranged in an in-plane direction of the sheet-like soft magnetic material. An acrylic rubber having a glycidyl group is used for the acrylic rubber. The weight ratio of the flat soft magnetic powder with respect to the total amount of the acrylic rubber, the epoxy resin, and the curing agent for the epoxy resin is 3.7 to 5.8. US 2009/110587 A1 discloses a method for producing a laminated soft-magnetic sheet by laminating thin soft-magnetic sheets produced by an application method. This document claims that a change in sheet thickness can be suppressed and variations in the magnetic permeability are small. The method for manufacturing a laminated soft-magnetic sheet includes the step (A) of obtaining curable soft-magnetic sheets, each of the curable soft-magnetic sheets being produced by applying to a release base a soft-magnetic composition prepared by mixing at least a flat soft-magnetic powder, an acrylic rubber having a glycidyl group, an epoxy resin, a latent curing agent for the epoxy resin, and a solvent, drying the applied soft-magnetic composition at a temperature T1 at which curing reaction of the soft-magnetic composition does not substantially take place, and removing the release base; the step (B) of obtaining a laminate of the curable soft-magnetic sheets by laminating at least two of the curable soft-magnetic sheets; the step (C) of compressing the obtained laminate at a temperature T2 at which the curing reaction does not substantially take place, using a laminator for applying a linear pressure thereon while the linear pressure is sequentially changed from a linear pressure PI, to a linear pressure P2, and to a linear pressure P3 (wherein P1<P2<P3); and the step (D) of obtaining a laminated soft-magnetic sheet by compressing the compressed laminate at a temperature T3 at which the curing reaction takes place, using a press for applying surface pressure thereon to final cure the laminate. JP 2012-212790 A1 discloses a magnetic sheet that contains (A) magnetic powder, (B) (a) acrylic rubber, (b) at least one kind of element selected from the group consisting of phenol resin and phenol aralkyl resin, (c) epoxy resin, (d) hardening accelerator and (e) binder resin obtained by hardening a resin composition containing a compound having a melamine structure, and (C) metal salt of phosphinic acid. The content of the compound having the melamine structure is equal to 25 mass% or more with respect to the total amount of the binder resin, and the content of phosphorus element is equal to 3.0 mass% or more with respect to the total amount of the binder resin and the metal salt of phosphinic acid.

JP 2014-069409 A discloses a sheet comprising particles such as particles of magnetic material in a mixture ratio of a thermoplastic resin such as acrylic resin, a thermosetting resin component such as an epoxy resin, which may be selected from a group comprising trishydroxy phenylmethane type epoxy resin and optionally a curing agent, which may be selected from a group including novolak-type phenol resin.

### Citation List

### Patent Document

Patent Document 1: Japanese Unexamined Patent Publication No. 2013-26324

### SUMMARY OF THE INVENTION

### PROBLEM TO BE SOLVED BY THE INVENTION

Recently, a thinner electronic device is demanded, and to ensure flatness of the soft magnetic film, it is demanded for the soft magnetic film that warping is suppressed in heating in reflow soldering.

However, the composite magnetic substance described in Patent Document 1 is disadvantageous in that the above-described demands are not sufficiently satisfied.

An object of the present invention is to provide a soft magnetic film with excellent magnetic permeability, and in which warping from heating can be suppressed, and a soft magnetic resin composition for forming the soft magnetic film.

### MEANS FOR SOLVING THE PROBLEM

The present invention relates to:
[1] a soft magnetic resin composition containing soft magnetic particles, epoxy resin, phenol resin, and acrylic resin, wherein the soft magnetic particle content relative to the soft magnetic resin composition is 60 vol% or more, and the soft magnetic resin composition after curing has a linear expansion coefficient of 22.0 ppm/°C or less, wherein the epoxy resin is trishydroxyphenylmethane epoxy resin and wherein the phenol resin is phenolnovolak resin;
[2] the soft magnetic film formed from the soft magnetic resin composition of [1]; and
[3] the soft magnetic film of [2], wherein the thickness is 500 µm or less.

### Effects of the Invention

The soft magnetic resin composition and soft magnetic film of the present invention contains soft magnetic particles, epoxy resin, phenol resin, and acrylic resin, and the soft magnetic particles content is a specific value or more, wherein the epoxy resin and phenol resin are as specified in appended claim 1.

Therefore, the soft magnetic resin composition and the soft magnetic film have excellent magnetic permeability, and the cured soft magnetic resin composition and soft magnetic film have a linear expansion coefficient of a specific value or less.

As a result, noise can be suppressed, and warping of the soft magnetic film after heating can be suppressed, and flatness of the heated soft magnetic film can be ensured.

### BRIEF DESCRIPTION OF THE DRAWINGS

FIG. 1 shows a cross-sectional view of a soft magnetic laminate circuit board including an embodiment of the soft magnetic film of the present invention.
FIG. 2A and FIG. 2B are diagrams illustrating the measurement of warping in Examples, FIG. 2A is a plan view, and FIG. 2B is a side view.

### DESCRIPTION OF EMBODIMENTS

The soft magnetic resin composition of the present invention contains soft magnetic particles, epoxy resin, phenol resin, and acrylic resin, wherein the epoxy resin and phenol resin are as specified in appended claim 1.

Examples of the soft magnetic materials that form the soft magnetic particles include magnetic stainless steel (Fe-Cr-Al-Si alloy), Sendust (Fe-Si-A1 alloy), permalloy (Fe-Ni alloy), silicon copper (Fe-Cu-Si alloy), Fe-Si alloy, Fe-Si—B (-Cu-Nb) alloy, Fe-Si-Cr-Ni alloy, Fe-Si-Cr alloy, Fe-Si-Al-Ni-Cr alloy, and ferrite. Among these, in view of magnetic characteristics, preferably, Sendust (Fe-Si-Al alloy) is used.

The soft magnetic particles are formed into a flat shape (platy). That is, the soft magnetic particles are formed into a shape having a small thickness and a large plane. The soft magnetic particles have an oblateness of, for example, 8 or more, preferably 15 or more, and for example, 80 or less, preferably 65 or less. The oblateness is calculated, for example, as an aspect ratio by dividing the average particle size (average length) of the soft magnetic particles with the average thickness of the soft magnetic particles.

The soft magnetic particles have an average particle size (average length) of, for example, 3.5 µm or more, preferably 10 µm or more, and for example, 100 µm or less. The average thickness is, for example, 0.3 µm or more, preferably 0.5 µm or more, and for example, 3 µm or less, preferably 2.5 µm or less. By adjusting the oblateness, average particle size, and average thickness of the soft magnetic particles, effects of demagnetizing field from the soft magnetic particles can be reduced, and as a result, magnetic permeability of the soft magnetic particles can be increased. To homogenize the size of the soft magnetic particles, as necessary, the soft magnetic particles can be classified using, for example, a sieve and used.

The soft magnetic particles have a specific gravity of, for example, 5.0 or more and 8.0 or less.

The soft magnetic resin composition has a soft magnetic particle volume percentage based on solid content of, 60 vol% or more, preferably 65 vol% or more, more preferably 70 vol% or more, and for example, 95 vol% or less, preferably 90 vol% or less. The soft magnetic resin composition has a soft magnetic particle mass percentage based on solid content of, for example, more than 85 mass%, preferably 88 mass% or more, more preferably 90 mass% or more, and for example, 98 mass% or less, preferably 95 mass% or less. The soft magnetic particle content of the above-described lower limit or more allows for a soft magnetic film with excellent magnetic characteristics. The soft magnetic particle content of the above-described upper limit or less allows for a soft magnetic resin composition with excellent film-forming characteristics.

The volume percentage of the components such as the soft magnetic particles is calculated based on the theoretical volume obtained by dividing the mass of the component with the specific gravity of the component. The specific gravity of the component is obtained based on catalogue value or by a known measurement method (e.g., specific gravity measurement method).

The epoxy resin is trishydroxyphenylmethane epoxy resin.

Trishydroxyphenylmethane epoxy resin is epoxy resin (polyfunctional monomer epoxy resin) composed of a polyfunctional monomer having two or more functional groups (glycidyl group) as a repeating unit, to be specific, trishydroxyphenylmethane epoxy resin represented by general formula (1) below.

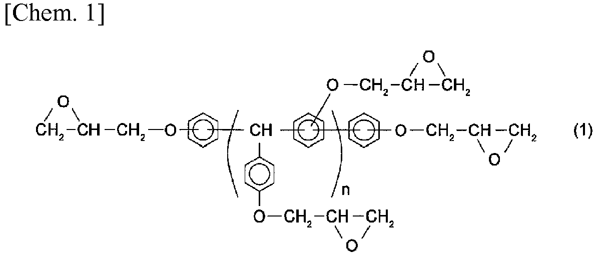

"n" represents a degree of polymerization of the monomer.

Trishydroxyphenylmethane epoxy resin is a polyfunctional monomer type epoxy resin, and has a low melting temperature, and can be crosslinked closely and cured with phenol resin. Therefore, when producing a high filling soft magnetic resin composition having a high soft magnetic particle content (to be specific, 60 vol% or more) by compressing the soft magnetic resin composition, cracks of the resin composition from repulsive power of the soft magnetic particles and hollow generation (spring-back) can be suppressed, and a soft magnetic resin composition with a low linear expansion coefficient can be more reliably produced.

The epoxy resin has an epoxy equivalent of, for example, 10 g/eq. or more, preferably 100 g/eq. or more, and for example, 500 g/eq. or less, preferably 180 g/eq. or less.

The epoxy resin has a viscosity (150°C) of, for example, 1.0Pa·s or less, preferably 0.2Pa·s or less, and 0.01Pa·s or more. The viscosity is measured by an ICI viscometer.

The epoxy resin has a specific gravity of, for example, 1.0 or more and 1.5 or less.

The mixing ratio of the epoxy resin is described later.

The phenol resin is a curing agent for epoxy resin, and it is phenolnovolak resin

The phenolnovolak resin has excellent reactivity with epoxy resin, and can improve resin strength.

The above-described epoxy resin and phenol resin compose thermosetting resin components. To be specific, of the thermosetting resin components, epoxy resin is a base compound, and phenol resin is a curing agent.

The phenol resin has a hydroxyl equivalent of, for example, 10 g/eq. or more, preferably 80 g/eq. or more, and for example, 500 g/eq. or less, preferably 150 g/eq. or less.

The phenol resin has a specific gravity of, for example, 1.0 or more and 1.5 or less.

The mixing ratio of the phenol resin is described later.

In view of more reliably producing a soft magnetic resin composition having a low linear expansion coefficient, for the combination of epoxy resin and phenol resin, trishydroxyphenylmethane epoxy resin and phenolnovolak resin is used.

That is, by using phenolnovolak resin that allows for a short crosslinking points distance with trishydroxyphenylmethane epoxy resin having a plurality of functional groups for repeating units, trishydroxyphenylmethane epoxy resin and phenolnovolak resin can crosslink each other closely more, and a high strength curing resin can be produced. Therefore, spring-back of the soft magnetic particles can be suppressed reliably, and a soft magnetic resin composition having a particularly low linear expansion coefficient can be produced more reliably.

Examples of the acrylic resin include an acrylic polymer produced by polymerizing monomer components of one, or two or more monomer components of alkyl (meth) acrylate having a straight chain or branched alkyl group. "(meth) acryl" represents "acryl and/or methacryl".

Examples of the alkyl group include an alkyl group having 1 to 20 carbon atoms such as a methyl group, ethyl group, propyl group, isopropyl group, n-butyl group, t-butyl group, isobutyl group, amyl group, isoamyl group, hexyl group, heptyl group, cyclohexyl group, 2-ethylhexyl group, octyl group, isooctyl group, nonyl group, isononyl group, decyl group, isodecyl group, undecyl group, lauryl group, tridecyl group, tetradecyl group, stearyl group, octadecyl group, and dodecyl group. Preferably, an alkyl group having 1 to 6 carbon atoms is used.

The acrylic polymer can be a copolymer of alkyl (meth) acrylate and other monomer.

Examples of the other monomer include glycidyl group-containing monomers such as glycidylacrylate and glycidylmethacrylate; carboxyl group-containing monomers such as acrylic acid, methacrylic acid, carboxyethylacrylate, carboxypentylacrylate, itaconic acid, maleic acid, fumaric acid, and crotonic acid; acid anhydride monomers such as maleic anhydride and itaconic acid anhydride; hydroxyl group-containing monomers such as 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate or (4-hydroxymethylcyclohexyl)-methylacrylate; sulfonic acid group-containing monomers such as styrenesulfonic acid, allylsulfonic acid, 2-(meth) acrylamide-2-methylpropane sulfonic acid, (meth) acrylamidepropane sulfonic acid, sulfopropyl (meth) acrylate, and (meth) acryloyloxynaphthalenesulfonic acid; phosphoric acid group-containing monomers such as 2-hydroxyethylacryloylphosphate; styrene monomers; and acrylonitrile. These can be used singly, or can be used in combination of two or more. Among these, preferably, acrylonitrile is used.

Acrylic resin preferably has an epoxy group. When the acrylic resin has an epoxy group, its epoxy value is, for example, 10eq./g or more, preferably 100eq./g or more, and for example, 800eq./g or less, preferably 500eq./g or less.

The acrylic resin has a weight-average molecular weight of, for example, 1 × 10⁵ or more, preferably 3 × 10⁵ or more, and for example, 1 × 10⁶ or less. The weight-average molecular weight is measured with a gel permeation chromatography (GPC) based on polystyrene standard calibration value.

The acrylic resin has a glass transition temperature of, for example, -20°C or more, preferably 0°C or more, more preferably 10°C or more, and for example, 50°C or less, preferably 30°C or less. The acrylic resin with the glass transition temperature of the above-described lower limit or more improves strength of the resin components, suppresses spring-back, and lowers linear expansion coefficient. Excellent handleability of the soft magnetic resin composition, and adherence of semi-cured soft magnetic resin composition are also achieved. The glass transition temperature is obtained based on the maximum value of loss tangent (tanδ) measured by using a dynamic viscoelasticity analyzer (DMA) with tensile mode (frequency 1Hz, temperature increase speed 10°C/min).

The acrylic resin has a specific gravity of, for example, 0.6 or more and 1.0 or less.

The soft magnetic resin composition has a total volume percentage of the resin component, that is, epoxy resin, phenol resin, and acrylic resin, based on solid content of, for example, 5 vol% or more, preferably 10 vol% or more, and for example, 35 vol% or less, preferably 30 vol% or less. The soft magnetic resin composition has a resin component mass percentage based on solid content of, for example, 2 mass% or more, preferably 5 mass% or more, and for example, less than 15 mass%, preferably 12 mass% or less, more preferably 10 mass% or less. The resin component content within the above-described range allows for excellent soft magnetic film-forming characteristics and magnetic characteristics.

The epoxy resin, phenol resin, and acrylic resin ( resin component) has an epoxy resin and a phenol resin (thermosetting resin component) volume percentage of, for example, 85 vol% or more, preferably 92 vol% or more, more preferably 95 vol% or more, and for example, 99 vol% or less, preferably 97 vol% or less.

The resin component has an epoxy resin volume percentage of, for example, 10 vol% or more, preferably 30 vol% or more, more preferably 55 vol% or more, more preferably 60 vol% or more, and for example, 90 vol% or less, preferably 80 vol% or less, more preferably 70 vol% or less. The resin component has an epoxy resin mass percentage of, for example, 10 mass% or more, preferably 30 mass% or more, preferably 40 mass% or more, and for example, 90 mass% or less, preferably 80 mass% or less, more preferably 70 mass% or less.

The resin component has a phenol resin volume percentage of, for example, 10 vol% or more, preferably 20 vol% or more, preferably more than 30 vol%, and for example, 90 vol% or less, preferably 70 vol% or less, more preferably less than 50 vol%, more preferably 40 vol% or less. The resin component has a phenol resin mass percentage of, for example, 10 mass% or more, preferably 20 mass% or more, more preferably more than 30 mass%, and for example, 90 mass% or less, preferably 70 mass% or less, more preferably less than 50 mass%.

The phenol resin content relative to 100 parts by volume of the epoxy resin is, for example, 10 parts by volume or more, preferably 50 parts by volume or more, and for example, 200 parts by volume or less, preferably less than 100 parts by volume.

The resin component has an acrylic resin volume percentage of, for example, 1.0 vol% or more, preferably 3.0 vol% or more, and for example, 15.0 vol% or less, preferably 8.0 vol% or less, more preferably 5.0 vol% or less. The resin component has an acrylic resin mass percentage of 1.0 mass% or more, preferably 3.0 mass% or more, and 15.0 mass% or less, preferably 8.0 mass% or less, more preferably 5.0 mass% or less. The acrylic resin content within the above-described range allows for a lower linear expansion coefficient of the soft magnetic resin composition.

The soft magnetic resin composition preferably contains a thermosetting catalyst.

The thermosetting catalyst is not limited as long as the catalyst accelerates curing of the resin component by heating, and examples thereof include an imidazole compound, a triphenylphosphine compound, a triphenylborane compound, and an amino group-containing compound. Preferably, an imidazole compound is used.

Examples of the imidazole compound include 2-phenylimidazole (product name;2PZ), 2-ethyl-4-methyl imidazole (product name; 2E4MZ), 2-methyl imidazole (product name; 2MZ), 2-undecylimidazole (product name; C11Z), 2-phenyl-1H-imidazole 4,5-dimethanol (product name; 2PHZ-PW), 2,4-diamino-6-(2'-methylimidazolyl (1)') and ethyl-s-triazine·isocyanuric acid adduct (product name; 2MAOK-PW)(above-described product are all manufactured by Shikoku Chemicals Corporation). These can be used singly, or can be used in combination of two or more.

The thermosetting catalyst has a specific gravity of, for example, 0.9 or more and 1.5 or less.

The thermosetting catalyst content relative to 100 parts by volume of the resin component is, for example, 0.1 parts by volume or more, preferably 0.3 parts by volume or more, and for example, 5 parts by volume or less, preferably 3 parts by volume or less. The thermosetting catalyst mass percentage relative to 100 parts by mass of the resin component is, for example, 0.1 parts by mass or more, preferably 0.3 parts by mass or more, and for example, 5 parts by mass or less, preferably 3 parts by mass or less. The thermosetting catalyst content within the above-described range allows for heating and curing of the soft magnetic resin composition with a low temperature and for a short period of time, and excellent reflow resistance.

The soft magnetic resin composition can contain, as necessary, a rheology control agent and/or a dispersing agent. The soft magnetic resin composition containing the rheology control agent allows more homogeneous dispersion of the soft magnetic particles in the soft magnetic resin composition. The soft magnetic resin composition containing the dispersing agent allows for more homogenous dispersion of the soft magnetic particles in the soft magnetic resin composition.

The rheology control agent is a thixotropic agent which imparts thixotropic properties to the soft magnetic resin composition; with the thixotropic properties, high viscosity is exhibited when shearing force (shearing speed) is low, and low viscosity is exhibited when shearing force (shearing speed) is high.

For the rheology control agent, for example, an organic rheology control agent and an inorganic rheology control agent are used. Preferably, an organic rheology control agent is used.

Examples of the organic rheology control agent include modified urea, urea modified polyamide, fatty acid amide, polyurethane, and polymer urea derivative. Preferably, modified urea, urea modified polyamide, and fatty acid amide are used, and more preferably, urea modified polyamide is used.

Examples of the inorganic rheology control agent include silica, calcium carbonate, and smectite.

Examples of the rheology control agent include, to be specific, "BYK-410", "BYK-430", and "BYK-431" manufactured by BYK Japan KK, " DISPERLON PFA-131" manufactured by Kusumoto Chemicals, Ltd., "AEROSIL VP NK 200", "AEROSIL R 976S", and "AEROSIL COK 84" manufactured by NIPPON AEROSIL CO., LTD.

These can be used singly, or can be used in combination of two or more.

The rheology control agent has a specific gravity of, for example, 0.6 or more and 1.0 or less.

The rheology control agent has a volume percentage relative to 100 parts by volume of the resin component of, for example, 0.1 parts by volume or more, preferably 1 part by volume or more, and for example, 10 parts by volume or less, preferably 5 parts by volume or less. The rheology control agent mass percentage relative to 100 parts by mass of the resin component is, for example, 0.1 parts by mass or more, preferably 1 part by mass or more, and for example, 10 parts by mass or less, preferably 5 parts by mass or less.

For the dispersing agent, for example, polyether phosphoric acid ester is used.

Examples of the polyether phosphoric acid ester include, to be specific, HIPLAAD series manufactured by Kusumoto Chemicals, Ltd. ("ED-152", "ED-153", "ED-154", "ED-118", "ED-174", and "ED-251").

The polyether phosphoric acid ester has an acid value of, for example, 10 or more, preferably 15 or more, and for example, 200 or less, preferably 150 or less. The acid value is measured by, for example, neutralization titration.

The dispersing agent has a specific gravity of, for example, 0.8 or more and 1.2 or less.

The dispersing agent has a volume percentage relative to 100 parts by volume of the resin component of, for example, 0.05 parts by volume or more, preferably 1 part by volume or more, and for example, 10 parts by volume or less, preferably 5 parts by volume or less. The polyetherphosphoric acid ester mass percentage relative to 100 parts by mass of soft magnetic particles is 0.01 parts by mass or more, preferably 0.05 parts by mass or more. The polyetherphosphoric acid ester mass percentage relative to 100 parts by mass of soft magnetic particles is 5 parts by mass or less, preferably 2 parts by mass or less.

The soft magnetic resin composition can contain resin other than epoxy resin, phenol resin, and acrylic resin, and as necessary, can contain other additives at a suitable ratio.

Examples of the resin other than epoxy resin, phenol resin, and acrylic resin include natural rubber, butyl rubber, isoprene rubber, chloroprene rubber, ethylene-vinyl acetate copolymer, polybutadiene resin, polycarbonate resin, thermoplastic polyimide resin, polyamide resin (6-nylon, 6,6-nylon, etc.), phenoxy resin, saturated polyester resin (PET, PBT, etc.), polyamide-imide resin, and fluorine resin. These can be used singly, or can be used in combination of two or more.

Examples of the additive include commercially available or known additives such as a crosslinking agent and an inorganic agent.

The soft magnetic resin composition is prepared by mixing the above-described components at the above-described contents.

The soft magnetic resin composition can be also prepared by a soft magnetic resin composition solution by mixing the above-described components with a solvent, and dissolving/dispersing the components in the solvent.

Next, description is given below of a soft magnetic film formed from the above-described soft magnetic resin composition.

The soft magnetic film is formed into a film from the above-described soft magnetic resin composition.

To be specific, the soft magnetic film can be produced by, for example, a step of preparing a soft magnetic resin composition solution by dissolving or dispersing a soft magnetic resin composition in a solvent; a step of drying in which a semi-cured soft magnetic film is obtained by applying and drying the soft magnetic resin composition solution on the surface of a release substrate; and a step of laminating and heat-pressing a plurality of soft magnetic films.

First, the soft magnetic resin composition is dissolved or dispersed in a solvent (preparation step). In this manner, the soft magnetic resin composition solution is prepared.

Examples of the solvent include organic solvents including ketones such as acetone and methyl ethyl ketone (MEK); esters such as ethyl acetate; ethers such as propylene glycol monomethylether; and amides such as N,N-dimethylformamide. Examples of the solvent also include water-based solvents including water, and alcohols such as methanol, ethanol, propanol, and isopropanol.

The soft magnetic resin composition solution has a solid content of, for example, 10 mass% or more, preferably 30 mass% or more, and for example, 90 mass% or less, preferably 85 mass% or less.

Then, the soft magnetic resin composition solution is applied on the surface of the release substrate (separator, core material, etc.), and dried (drying step).

The application method is not particularly limited, and for example, doctor blade method, roll application, screen application, and gravure coating are used.

The drying conditions are as follows: the drying temperature of, for example, 70°C or more and 160°C or less, and the drying time of, for example, 1 minute or more and 5 minutes or less.

For the separator, for example, polyethylene terephthalate (PET) film, polyethylene film, polypropylene film, and paper are used. The surface of these examples of separator is treated with, for example, fluorine releasing agent, long-chain alkylacrylate releasing agent, and silicone releasing agent for releasing.

Examples of the core material include plastic films such as polyimide film, polyester film, polyethylene terephthalate film, polyethylenenaphthalate film, and polycarbonate film; metal films such as aluminum foil; and resin substrate, silicon substrate, and glass substrate reinforced with glass fiber and plastic-made nonwoven fiber.

The separator or core material has an average thickness of, for example, 1 µm or more and 500 µm or less.

The semi-cured (B-stage state) soft magnetic film is produced in this manner.

The soft magnetic film has an average thickness of, for example, 5 µm or more, preferably 50 µm or more, and for example, 500 µm or less, preferably 250 µm or less.

Then, the produced soft magnetic films are prepared in a plural number, and the plurality of soft magnetic films are heat-pressed in the thickness direction with a heat press (heat pressing step). In this manner, the semi-cured soft magnetic film is heated and cured. Furthermore, the soft magnetic film can be charged with soft magnetic particles at a high percentage, and magnetic characteristics can be improved.

The heat pressing can be performed by using a known press, for example, such as a parallel plate press.

The soft magnetic film can be laminated to a number of, for example, 2 or more, and for example, 20 or less, preferably 5 or less. In this manner, the soft magnetic film can be adjusted to a desired thickness.

The heating temperature is, for example, 80°C or more, preferably 100°C or more, and for example, 200°C or less, preferably 180°C or less.

The heating time is, for example, 0.1 hours or more, preferably 0.2 hours or more, and for example, 24 hours or less, preferably 2 hours or less.

The pressure is, for example, 10MPa or more, preferably 20MPa or more, and for example, 500MPa or less, preferably 200MPa or less.

In this manner, the soft magnetic film is heated and cured, and a cured (C-stage state) soft magnetic film is produced.

The soft magnetic film has a thickness of, as an average thickness, for example, 5 µm or more, preferably 50 µm or more, and for example, 500 µm or less, preferably 250 µm or less. When the thickness is more than the above-described upper limit, the soft magnetic film, and the electronic device including the soft magnetic film may not be made thin. When the thickness is below the above-described lower limit, the soft magnetic film with excellent magnetic permeability may not be made.

The cured (C-stage state) soft magnetic film has, under temperature ranges of both below the glass transition temperature and the glass transition temperature or more, a linear expansion coefficient of 22.0 ppm/°C or less, linear expansion coefficient of preferably 20.5 ppm/°C or less, more preferably linear expansion coefficient of 18.0 ppm/°C or less, more preferably a linear expansion coefficient of 15.0 ppm/°C or less, and for example, linear expansion coefficient of 10.0 ppm/°C or more.

Meanwhile, when the cured soft magnetic film does not have a linear expansion coefficient of the above-described upper limit or less, warping of cured soft magnetic film in heating at reflow step may not be suppressed.

To be specific, the cured soft magnetic film has a linear expansion coefficient α₁ under blow glass transition temperature of, for example, 18.0 ppm/°C or less, preferably 17.0 ppm/°C or less, more preferably 16.0 ppm/°C or less, more preferably 15.0 ppm/°C or less, and 10.0 ppm/°C or more.

When the linear expansion coefficient α₁ under below glass transition temperature is more than the above-described upper limit, warping of the cured soft magnetic film at a first stage of heating in the reflow step may not be suppressed.

The cured soft magnetic film has a linear expansion coefficient α₂ under glass transition temperature or more of, for example, 22.0 ppm/°C or less, preferably 21.0 ppm/°C or less, more preferably 20.5 ppm/°C or less, and 15.0 ppm/°C or more.

When the linear expansion coefficient α₂ under the glass transition temperature or more is more than the above-described upper limit, warping of the cured soft magnetic film at a later stage of heating in the reflow step may not be suppressed.

The cured soft magnetic film preferably has a specific value of the above-described linear expansion coefficient α₁ or less at below the glass transition temperature, and has a specific value of the above-described linear expansion coefficient α₂ or less at the glass transition temperature or more. When the linear expansion coefficient α₁ below the glass transition temperature and the linear expansion coefficient α₂ under the glass transition temperature or more are the above-described specific value or less, warping of the soft magnetic film can be suppressed in all stages of reflow step.

The soft magnetic film has a glass transition temperature of, for example, 40°C or more. The glass transition temperature is preferably 60°C or more, more preferably 80°C or more, and for example, 200°C or less, preferably 180°C or less. The glass transition temperature of the soft magnetic film is obtained based on the maximum value of loss tangent (tanδ)measured using a dynamic viscoelasticity analyzer (DMA) with tensile mode (frequency 1Hz, temperature increase speed 10°C/min).

In the soft magnetic film, preferably, the flat soft magnetic particles contained in the soft magnetic film are oriented in the two-dimensional in-surface direction of the soft magnetic film. That is, the flat soft magnetic particles contained in the soft magnetic film are oriented so that the longitudinal direction of the flat soft magnetic particles (direction perpendicular to the thickness direction) is along the surface direction of the soft magnetic film. In this manner, the soft magnetic film is filled with the soft magnetic particles at a high percentage, and has excellent magnetic characteristics. Furthermore, there is an attempt to make the soft magnetic film thin.

The soft magnetic film can be in forms of, for example, a single-layer structure composed only of a single layer of soft magnetic film, a multiple layer structure in which the soft magnetic film is laminated on one or both sides of the core material, and a multiple layer structure in which the separator is laminated on one or both sides of the soft magnetic film.

In the above-described embodiment, the plurality of soft magnetic films are laminated and heat pressed. But for example, the heat pressing can be performed for a single soft magnetic film (single layer) as well.

The soft magnetic film is used, for example, for electronic devices. To be specific, the soft magnetic film is suitably used for antennas, coils, or as a soft magnetic film to be laminated in circuit boards in which antennas or coils are formed on its surface and in which electronic elements are mounted.

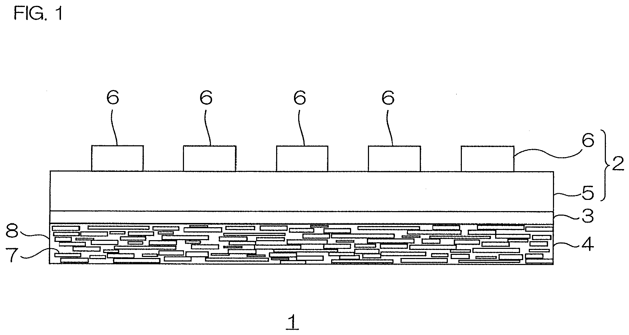

To be specific, the soft magnetic film can be used, for example, as shown in FIG. 1, as a soft magnetic film laminate board 1 including a circuit board 2, a laminate layer 3 disposed on the lower face (one side) of the circuit board 2, and a soft magnetic film 4 disposed on the lower face of the laminate layer 3.

The circuit board 2 is, for example, a circuit board 2 of electromagnetic induction system, and on the upper face (one side) of the substrate 5, a wiring pattern 6 such as loop coils is formed. The wiring pattern 6 is formed, for example, by semi-additive method or subtractive method.

Examples of the insulating materials forming the substrate 5 include glass epoxy substrate, glass substrate, PET substrate, Teflon substrate, ceramic substrate, and polyimide substrate.

For the laminate layer 3, a known one usually used for adhesives for the circuit board 2 is used, and for example, is formed by applying and drying an adhesive such as an epoxy adhesive, a polyimide adhesive, and an acrylic adhesive. The laminate layer 3 has a thickness of, for example, 10 to 100 µm.

The soft magnetic film 4 is the aforementioned soft magnetic film, and flat soft magnetic particles 7 are dispersed in the soft magnetic resin composition (to be specific, cured resin 8 in which the resin component is cured). Preferably, the soft magnetic particles 7 are oriented so that its longitudinal direction (direction perpendicular to thickness direction) is along the surface direction of the soft magnetic film 4.

Such a soft magnetic film laminate board 1 is used, for example, for smartphones, personal computers, and position detection devices.

In the embodiment of FIG. 1, the laminate layer 3 is provided between the circuit board 2 and the soft magnetic film 4. But for example, although not shown, the soft magnetic film 4 can be provided so as to directly contact the circuit board 2.

To directly laminate the soft magnetic film 4 on the circuit board 2, the semi-cured soft magnetic film is directly bonded to the circuit board 2, and then the soft magnetic film is heated and cured.

The temperature in the reflow step is, for example, 200°C or more, preferably 250°C or more, and for example, 500°C or less, preferably 300°C or less.

The reflow retention time is, for example, 1 second or more, preferably 5 seconds or more, and for example, 10 minutes or less, preferably 5 minutes or less.

The soft magnetic film after the reflow step has a relative magnetic permeability µ' of, for example, 120 or more, preferably 130 or more, more preferably 140 or more, and for example, 500 or less.

The soft magnetic resin composition and the soft magnetic film contain soft magnetic particles, epoxy resin, phenol resin, and acrylic resin, and the soft magnetic particle volume percentage based on solid content relative to the soft magnetic resin composition is 60 vol% or more, wherein the epoxy resin and the phenol resin are as specified in appended claim 1.

Therefore, the soft magnetic resin composition and the soft magnetic film have excellent magnetic permeability, and the cured soft magnetic resin composition and soft magnetic film can have a linear expansion coefficient of 22.0 ppm/°C or less.

As a result, noises in electronic devices can be suppressed, and warping of the soft magnetic film from heating can be suppressed, and flatness of the heated soft magnetic film can be ensured. Therefore, electrical appliances including the soft magnetic film can be made thin.

In the present invention, the film is also defined as tapes or sheets.

In the above description, the soft magnetic film is formed from the soft magnetic resin composition of the present invention, but for example, although not shown, the soft magnetic resin composition can be made into a soft magnetic block of formless or formed block (soft magnetic material), and in such a case as well, the soft magnetic block has the specific linear expansion coefficient described above.

### Examples

In the following, the present invention is described in further detail with reference to Examples and Comparative Examples. However, the present invention is not limited to these Examples and Comparative Examples. The specific numeral values such as mixing ratio (content), physical property values, and parameters used in the description below can be replaced with the upper limit value (numeral values defined with "or less", "less than") or the lower limit value (numeral values defined with "or more", "more than") of the corresponding mixing ratio (content), physical property values, parameters in the above-described "DESCRIPTION OF

### EMBODIMENTS".

### Example 1

A soft magnetic resin composition was produced by mixing 500 parts by mass of Fe-Si-Al alloy, 21.9 parts by mass of the above-described epoxy resin represented by general formula (1) (manufactured by Nippon Kayaku Co., Ltd., EPPN-501HY) as epoxy resin, 13.5 parts by mass of phenol novolak resin (manufactured by Gunei Chemical Industry Co., Ltd., Resitop LVR 8210DL) as phenol resin, 8.6 parts by mass of acrylate copolymer (manufactured by Nagase ChemteX Corporation., TEISANRESIN SG-P 3) as acrylic resin, 0.5 parts by mass of polyetherphosphoric acid ester (manufactured by Kusumoto Chemicals, Ltd., ED 152) (0.1 parts by mass relative to 100 parts by mass of soft magnetic particles) as dispersing agent, 0.28 parts by mass of 2-phenyl-1H-imidazole 4,5-dimethanol (manufactured by Shikoku Chemicals Corporation, CUREZOL 2PHZ-PW) (1.0 part by mass relative to 100 parts by mass of the resin component) as thermosetting catalyst, and 3 parts by mass of BYK-430 (manufactured by BYK Japan KK) as rheology control agent so that the soft magnetic particle volume percentage based on solid content relative to the soft magnetic resin composition was 70.0 vol%.

Table 1 shows the volume percentage (solid content vol%) of the components of the soft magnetic resin composition.

The soft magnetic resin composition was dissolved in MEK, thereby preparing a soft magnetic resin composition solution of a solid content concentration of 85 mass%.

### Example 2 and Comparative Examples 1 to 2

A soft magnetic resin composition was produced in the same manner as in Example 1, except that the components shown in Table 1 were mixed at the mixing ratios shown in Table 1, and thereafter, a soft magnetic resin composition solution was prepared.

### (Thermal expansion coefficient)

A soft magnetic resin composition solution of Examples and Comparative Examples was applied on a separator treated for releasing, and thereafter, dried under a heat environment of 110°C for 2 minutes. In this manner, a semi-cured soft magnetic film (average thickness 50 µm) was prepared.

Then, three of the soft magnetic films were laminated to produce a laminate, and the laminate was heat pressed with a vacuum heat press (manufactured by Mikado Technos Co., Ltd.) at 175°C for 30 minutes, 40MPa to be heated and cured, thereby producing a completely cured soft magnetic film (average thickness 150 µm).

The produced soft magnetic film was subjected to thermomechanical measurement based on the following conditions to obtain thermal expansion coefficient (linear expansion coefficient below glass transition temperature was α₁ and linear expansion coefficient at glass transition temperature or more was α₂).

Thermomechanical analyzer (TMA):TMA (manufactured by TA Instruments. Japan.
Sample size: 4 mm × 16 mm
Mode: tensile mode
Temperature increase speed: 5°C/min
Measurement temperature range: -50°C to 300°C

Separately, the glass transition temperature was obtained based on the maximum value of loss tangent (tanδ)measured by using a dynamic viscoelasticity analyzer (DMA) with tensile mode (frequency 1Hz, temperature increase speed 10°C/min).

### (Warping measurement)

The soft magnetic resin composition solution of Examples and Comparative Examples was applied on a separator treated for release, and thereafter, dried under heat atmosphere of 110°C for 2 minutes. A semi-cured soft magnetic film (average thickness 50 µm) was produced in this manner.

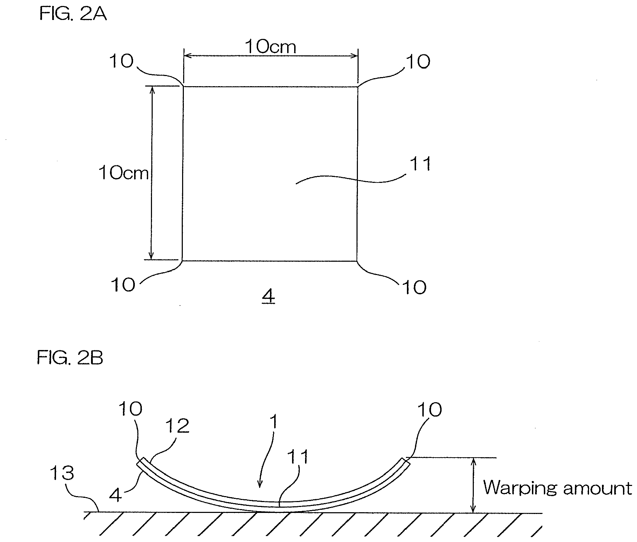

Then, three of the soft magnetic film was laminated, as shown in FIG. 2A and FIG. 2B, and a Cu foil 12 was further laminated thereon to produce a laminate. After the laminate was trimmed into a size of 10 cm × 10 cm, the laminate was heated and cured by heat pressing with a vacuum heat press (manufactured by Mikado Technos Co., Ltd.) under the conditions of 175°C for 30 minutes under vacuum at 1000Pa to bond with the Cu foil 12, thereby producing a completely cured soft magnetic film 4 (average thickness 162 µm) laminated on the Cu foil 12.

The soft magnetic film 4 and the Cu foil 12 were passed through a reflow oven for 5 minutes with a peak temperature of 260°C.

This caused four corners 10 of the soft magnetic film 4 warped relative to a center portion 11. To be specific, the corner 10 curled so that the contacting face of the corner 10 relative to the Cu foil 12 moves to the Cu foil 12 side.

Thereafter, the soft magnetic film 4 and the Cu foil 12 after the reflow step were placed on a pedestal 13 having a flat upper face so that the soft magnetic film 4 faces downward. That is, the center portion 11 of the soft magnetic film 4 was allowed to contact the upper face of the pedestal 13. Then, each of the four corners 10 of the soft magnetic film 4 was positioned (lifted) in spaced-apart relation above relative to the pedestal 13.

Then, the average value of the distance from each of the four corners 10 and the pedestal 13 was determined as a warping amount.

### (Relative magnetic permeability)

The relative magnetic permeability of the soft magnetic film produced in Examples and Comparative Examples was obtained by measuring the impedance using an impedance analyzer (manufactured by Agilent Technologies, product number "4294A").

**[Table 1]**

| Table 1 | | | | Units are all in vol% | | |
|---|---|---|---|---|---|---|
| | | | Example 1 | Example 2 | Comparative Example 1 | Comparative Example 2 |
| Soft magnetic particles | Fe-si-al alloy | | 70.0 | 60.0 | 45.0 | 30.0 |
| Resin component | Acrylic resin | SG-P3 | 1.3 | 1.8 | 2.5 | 3.4 |
| | Phenol resin | LVR8210DL | 10.2 | 13.8 | 19.2 | 24.7 |
| | Epoxy resin | EPPN501HY | 16.7 | 22.6 | 31.5 | 40.1 |
| Dispersing agent | ED-152 | | 0.5 | 0.4 | 0.3 | 0.2 |
| Rheology control agent | BYK-430 | | 1.0 | 1.0 | 1.0 | 1.0 |
| Thermosetting catalyst | CUREZOL 2PHZ-PW | | 0.3 | 0.4 | 0.5 | 0.6 |
| Linear expansion coefficient (ppm/°C) | | α₁ | 15.3 | 13.0 | 21.4 | 19.7 |
| | | α₂ | 20.6 | 20.3 | 23.7 | 22.4 |
| Warping amount before and after (mm) before and after reflow | | | 1.0 | 1.0 | 3.5 | 4.0 |
| Glass transition temperature (°C) | | | 170 | 170 | 170 | 170 |
| Relative magnetic permeability (@1mhz) | | | 144 | 150 | 128 | 82 |

The values in the Table for the components show solid contents. The details of the components in Examples and Comparative Examples, and Table are shown below.
- Fe-Si-Al alloy: product name "FME 3DH", soft magnetic particles, flat, average particle size 43 µm, average thickness 1 µm, specific gravity 6.8, manufactured by SANYO SPECIAL STEEL Co., Ltd.
- SG-P 3: acrylic rubber solution, product name "TEISANRESIN SG-P 3", epoxy group-containing ethyl acrylate-butyl acrylate-acrylonitrile copolymer, specific gravity 0.85, weight-average molecular weight 8.5 × 10⁴, epoxy value 210eq./g, glass transition temperature 12°C, rubber content 15 mass%, solvent: methyl ethyl ketone, manufactured by Nagase ChemteX Corporation.
- LVR 8210DL: phenol novolak resin: product name "Resitop LVR 8210DL", hydroxyl equivalent 104 g/eq., specific gravity 1.2, manufactured by Gunei Chemical Industry Co., Ltd.
- EPPN-501HY: above-described epoxy resin represented by general formula (1), product name "EPPN-501HY", epoxy equivalent 169 g/eq., ICI viscosity (150°C) 0.1Pa·s, specific gravity 1.25, manufactured by Nippon Kayaku Co., Ltd.
- ED 152: polyetherphosphoric acid ester: product name "HIPLAAD ED 152", polyetherphosphoric acid ester, acid value 17, specific gravity 1.03, manufactured by Kusumoto Chemicals, Ltd.
- BYK-430:product name, rheology control agent, urea modified mid-polar polyamide, specific gravity 0.86, solid content 30 mass%, mixture solution of isobutyl alcohol and solvent naphtha, manufactured by BYK Japan KK
- 2PHZ-PW:thermosetting catalyst, 2-phenyl-1H-imidazole 4,5-dimethanol, specific gravity 1.33, product name "CUREZOL 2PHZ-PW", manufactured by Shikoku Chemicals Corporation

While the illustrative embodiments of the present invention are provided in the above description, such is for illustrative purpose only and it is not to be construed as limiting in any manner. Modification and variation of the present invention is possible within the scope of the appended claims.

### Industrial Applicability

The soft magnetic resin composition and the soft magnetic film of the present invention can be applied to various industrial products, and for example, can be suitably used for mobile terminals such as smartphones and tablet computers, and position detection devices.

### Description of reference numeral

- 4: soft magnetic film
- 7: soft magnetic particles

## Claims

1. A soft magnetic resin composition comprising soft magnetic particles, epoxy resin, phenol resin, and acrylic resin,
wherein the epoxy resin is trishydroxyphenylmethane epoxy resin, and the phenol resin is phenolnovolak resin, and
the soft magnetic particle content relative to the soft magnetic resin composition is 60 vol% or more,
the soft magnetic resin composition after curing has a linear expansion coefficient of 22.0 ppm/°C or less,
**characterised in that**
a total amount of the epoxy resin, the phenol resin, and the acrylic resin has an acrylic resin mass percentage of 1.0 mass% or more and 15.0 mass% or less.

2. A soft magnetic film formed from the soft magnetic resin composition according to Claim 1.

3. The soft magnetic film according to Claim 2, wherein the soft magnetic film has a thickness of 500 µm or less.

## Patentansprüche

1. Weichmagnetische Harzzusammensetzung, umfassend weichmagnetische Teilchen, Epoxyharz, Phenolharz und Acrylharz,
wobei das Epoxyharz Trishydroxyphenylmethan-Epoxyharz ist und das Phenolharz Phenolnovolakharz ist, und
der Gehalt an weichmagnetischen Teilchen, bezogen auf die weichmagnetische Harzzusammensetzung, 60 Vol.-% oder mehr beträgt, und
die weichmagnetische Harzzusammensetzung nach dem Härten einen linearen Ausdehnungskoeffizienten von 22,0 ppm/°C oder weniger aufweist,
**dadurch gekennzeichnet, dass** die Gesamtmenge des Epoxyharzes, des Phenolharzes und des Acrylharzes einen Acrylharz-Massenprozentsatz von 1,0 Massenprozent oder mehr und 15,0 Massenprozent oder weniger aufweist.

2. Weichmagnetischer Film, gebildet aus der weichmagnetischen Harzzusammensetzung gemäß Anspruch 1.

3. Weichmagnetischer Film gemäß Anspruch 2, wobei der weichmagnetische Film eine Dicke von 500 µm oder weniger aufweist.

## Revendications

1. Composition de résine faiblement magnétique comprenant des particules faiblement magnétiques, une résine époxy, une résine phénolique et une résine acrylique,
dans laquelle la résine époxy est une résine époxy de trishydroxyphénylméthane, et la résine phénolique est une résine phénolnovolaque, et
la teneur en particules faiblement magnétiques par rapport à la composition de résine faiblement magnétique est de 60 % en volume ou plus,
la composition de résine faiblement magnétique après durcissement présente un coefficient de dilatation linéaire de 22,0 ppm/°C ou moins,
**caractérisée en ce que**
une quantité totale de la résine époxy, de la résine phénolique et de la résine acrylique présente un pourcentage en masse de résine acrylique de 1,0 % en masse ou plus et de 15,0 % en masse ou moins.

2. Film faiblement magnétique formé à partir de la composition de résine faiblement magnétique selon la revendication 1.

3. Film faiblement magnétique selon la revendication 2, dans lequel le film faiblement magnétique présente une épaisseur de 500 µm ou moins.
